# EUROPEAN PATENT SPECIFICATION

(11) **EP 4 487 437 B1**
(45) Date of publication and mention of the grant of the patent: **06.05.2026**
(21) Application number: 22712889.9
(22) Date of filing: 01.03.2022
(51) Int. Cl.: H02J 3/18, H02M 7/483, H02J 3/36, G01R 19/25

(54) **CONDITION MONITORING OF ELECTRONIC COMPONENTS IN ELECTRICAL POWER SYSTEMS**
ZUSTANDSÜBERWACHUNG VON ELEKTRONISCHEN KOMPONENTEN IN ELEKTRISCHEN STROMVERSORGUNGSSYSTEMEN
SURVEILLANCE D'ÉTAT DE COMPOSANTS ÉLECTRONIQUES DANS DES SYSTÈMES D'ALIMENTATION ÉLECTRIQUE

(43) Date of publication of application: 08.01.2025
(73) Proprietor: Hitachi Energy Ltd, 8050 Zürich (CH)
(72) Inventor: ASOODAR, Mohsen, 164 56 Stockholm (SE); DANIELSSON, Christer, 725 91 Västerås (SE)
(74) Representative: AWA Sweden AB
(86) International application number: PCT/EP2022/055113
(87) International publication number: WO 2023/165680

(56) References cited:
- EP-A1- 3 133 710
- US-B2- 10 473 728
- REN LEI ET AL: "Monitoring transistor degradation in power electronic converters using saturation-region resistance", 2017 IEEE ENERGY CONVERSION CONGRESS AND EXPOSITION (ECCE), IEEE, 1 October 2017 (2017-10-01), pages 1148 - 1153, XP033246933, DOI: 10.1109/ECCE.2017.8095918

## Description

### TECHNICAL FIELD

The present disclosure relates to electrical power systems, such as MMCs or (E-)STATCOMs. More particularly, the present disclosure relates to a method for monitoring the condition of electronic components in electrical power systems.

### BACKGROUND

Power stations may commonly comprise power electronic converter devices (e.g. voltage-source converter devices) that can act as either a source or sink of reactive AC power for a power grid. An example of such a device is a static synchronous compensator (STATCOM) or a modular multilevel converter (MMC) used in, for example, a high voltage direct current (HVDC) application. Some power stations may further comprise energy storage systems for storing electrical energy, e.g. such that electrical energy can be stored during times of electrical production surplus, and provided to the power grid during times of electrical production deficit. Power stations comprising STATCOM devices and energy storage systems may be referred to as employing 'enhanced' STATCOM, or 'E-STATCOM' devices.

A converter may comprise a plurality of submodules connected in series, e.g. in one or more arms, such that if an arm of the converter has N submodules, the converter output voltage will have N+1 or 2N+1 levels (e.g. depending on whether submodules comprise half- or full-bridges, respectively), where each level is a voltage contribution for each step of the step-wise built output waveform for the converter (i.e. N levels of V_{SM} plus zero, where V_{SM} is a voltage contribution from a single submodule). Thus, typically, the more levels a converter has, the more a step-wise-built output waveform may approximate an AC waveform, for example.

Submodules of such converters may typically comprise capacitors connected to modulated switches, these electronic components being arranged in e.g. a half-bridge or full-bridge configuration. The switches may be modulated (e.g. by a converter control unit) in such a way as to switch the capacitors into and out of a contribution to a voltage output of the converter so as to build an output waveform in a stepwise fashion. The modulation scheme may be configured such that the output waveform approximates an AC waveform.

An energy storage system may comprise a plurality of energy storage units (ESUs) connected in series, e.g. in one or more strings, wherein each ESU may comprise a battery management system (BMS), which may also be referred to as an energy storage management system (ESMS), configured to balance the amounts of stored electrical energy between ESUs in a string. The BMS may comprise a capacitor and a balancing resistor, which may be engaged via a balancing switch.

In electrical power systems, the electrical components (e.g. in submodules and/or ESUs) may be subject to high voltages and high currents, especially in high voltage direct current (HVDC) applications. Hence, degradation of these components can be expected under these conditions. Condition monitoring of such high-power components may thus be desired. Condition monitoring may, for example, improve an understanding of the current operational state of such high-power components. Moreover, 'online' condition monitoring (i.e. monitoring whilst components are in use) can help identify where maintenance may be needed, and how urgent the maintenance work may be.

US 10 473 728 B2 discloses a possibility to determine the states of charge and energy levels of the energy stores using a small number of measuring systems for easier operation of multilevel converters. Furthermore, in the paper "Monitoring transistor degradation in power electronic converters using saturation-region resistance" by Ren Lei et al. a health monitoring method using the saturation-region resistance is proposed to identify the level of aging associated with power semiconductor switches is disclosed. Finally, EP 3 133 710 A1 concerns a Modular Multilevel power Converter (MMC) Statcom with an extended preferred application range or power rating.

### SUMMARY

The invention refers to a computer-implemented method for monitoring a converter, according to claim 1, a computer-implemented method for monitoring an energy storage system, according to claim 9, control units, according to the claims 10 and 11, a power station, according to claim 12, and a computer-readable medium, according to claim 14.

Preferred embodiments are defined in the dependent claims.

It is therefore an object of the present disclosure to provide an improved monitoring of the condition of electronic components in electrical power systems. In particular, and as a particular advantage of the presently disclosed approach, an accurate monitoring technique is provided without requiring additional hardware. This and other objects are achieved by means of a method as defined in the appended independent claims. Other embodiments are defined by the dependent claims.

According to an aspect of the present disclosure, there is provided a computer-implemented method for monitoring a converter, the converter comprising a plurality of series-connected submodules. According to another aspect of the present disclosure, there is provided a computer-implemented method for monitoring an energy storage system (ESS) comprising a plurality of series-connected energy storage units (ESUs).

Thus, it can be seen that aspects of the present disclosure are generally directed to a monitoring system applicable to power electronics systems.

According to a further aspect of the present disclosure, there is provided a power station comprising a static synchronous compensator (STATCOM) for use with a power grid, comprising at least one converter, and a control unit configured to monitor/control the converter. The control unit may comprise means for carrying out the presently disclosed method for monitoring the converter.

According to an aspect, the control unit may be loaded with a computer-readable medium comprising instructions which, when executed by a computer (e.g. a computer comprised in the control unit), cause the computer to carry out the presently disclosed method for monitoring a converter.

The power station may further comprise an energy storage system having a plurality of energy storage units. In such cases, the power station may further comprise a control unit configured to control/monitor the ESS. It will be appreciated that this control unit may be the same unit as that used to control/monitor the converter, or it may be a separate control unit.

Irrespective of the particular construction of the ESS control unit, it may similarly comprise means for carrying out the presently disclosed method for monitoring an energy storage system, e.g. a computer having a computer-readable medium loaded thereupon for execution.

According to the presently disclosed approach, each submodule/ESU has electrical/electronic components (or simply 'components') arranged in a same circuit topology. For example, each submodule in a plurality of submodules comprised in a converter may have a full-bridge submodule topology, or a half-bridge module topology, formed of a capacitor and a plurality of semiconductor switches. A full-bridge submodule topology may comprise four semiconductor switches electrically connected to a capacitor such that a modulated operation of the switches may produce an AC waveform from a DC input. A half-bridge submodule topology may function similarly, but with two switches instead of four.

As used herein, the 'topology' of a circuit may be thought of as the relative electrical position of a component in a circuit, decoupled from any consideration of the physical position of said component. Thus, components having a same position in a same circuit topology may experience the same electrical behavior under the same electrical conditions.

According to aspects of the present disclosure, the monitoring method comprises determining, for each electrical component in a group, a component value for an electrical characteristic, determining, for the group of electrical components, a group value for the electrical characteristic, and determining a deviation of the component value from the group value for at least one electrical component in the group. The method then comprises determining a health status for said at least one electrical component of the group based on the determined deviation for the electrical component.

According to this approach, electrical characteristics indicative of a health status of an electrical component, but which are temperature-dependent, may advantageously be used to determine a health status for electrical components without the addition of further sensors.

When determining a group value, which may be an average (e.g. mean, median) of the component values for each electrical component in the group, it may validly be assumed that each electrical component in the group is experiencing a similar thermal variation. This can be attributed to the advantageous definition of the group.

A 'group' is defined by as being a corresponding electrical component from each submodule, in the plurality of submodules, having a same position in the circuit topology of their respective submodule. For example, in submodules that all have a full-bridge submodule topology, the capacitor in each submodule will be arranged in a same position in the full-bridge submodule topology. Similarly, each of the plurality of semiconductor switches will have a position in the circuit topology such that switches in a same position in different submodules will experience a same electrical behavior (e.g. according to the modulation scheme for the converter).

Thus, as each electrical component in said group is experiencing the same electrical behavior, it can be assumed that the average power losses for each component in the group are the same, considering also that the plurality of submodules/ESUs are connected in series such that current is evenly shared thereacross.

As used herein, 'same average power losses' and similar such terms will be appreciated as meaning that transient losses may not be exactly the same since, for example, similar positioned components may not be modulated (i.e. switched) in exactly the same way. Hence, the assumption of even power losses and temperature changes can be thought of as referring to average power losses (i.e. over a period of time such as one or many modulation cycles) and average temperature changes.

The power losses may be assumed as following a power model for the component being monitored, and may be a function of voltage/current flowing through said component and/or the voltage/current on a group level, e.g. a group current. An example of a group current may be an 'arm current' flowing through an arm of a converter comprising a plurality of submodules. A modulation scheme (i.e. for a converter) may also contribute to expected power losses of the components in the converter.

The thermal response of the component to said power losses may then be assumed as following a thermal model for the component. Each corresponding component may have a similar thermal model by virtue of having a similar composition and construction.

Thus, according to the presently disclosed techniques, it has been realized that the expected thermal response for each component in a group, as defined above, will be substantially the same. Hence, during operation of a converter or ESS, the temperature-associated variations in electrical characteristics of components in the group can be validly assumed to be substantially the same.

It thus follows that a significant deviation of a component value for a (temperature-dependent) electrical characteristic from the group value can be attributed only to poor health of the individual component having said deviating component value.

As such, a health status of electrical components can be accurately determined based on a temperature-dependent electrical characteristic, without requiring the addition of temperature sensors. Hence, the presently disclosed methods may be implemented without requiring costly installation of further hardware.

The electrical characteristic may be directly measured (e.g. using additional electrical measurements/sensors) or it may be determined based on electrical outputs already available as part of a control or monitoring scheme for the electrical power system. For example, converter control units may have modulation schemes, capacitor voltages, arm currents, etc. readily available as part of the existing control and monitoring system. Therefore, it may advantageously further reduce the number of required additional sensors (e.g. to zero) if such already-available inputs/outputs are used in the determination of component or group values for the electrical characteristic.

According to the present approach, it is realized that electrical characteristics of electrical components in converters and/or ESSs may be determined (i.e. estimated to a sufficient degree of accuracy for use in health/condition monitoring) from the values of current, voltage etc. that are already monitored/controlled as part of the control/monitoring system of the converter/ESS. Only in cases where the existing inputs/outputs are insufficiently accurate for use in health monitoring may additional electrical sensors be required.

As used herein, electrical characteristics can be thought of as any value that is characteristic of electrical behavior/properties of an electrical component in such a way as to enable a monitoring of the health of said electrical component. For example, the electrical characteristic monitored for capacitors in submodules or ESUs may be capacitance. However, an electrical characteristic may also be, for example, an integration of the voltage and divided by an integration of the current, considering that such a parameter may be useful in assessing the health/condition of a component.

Following the example of determining capacitance of a capacitor, the capacitance may be determined using a dedicated electrical sensor, or without additional sensors. In order to determine capacitance without sensors, it is advantageously realized according to the present approach that a capacitance of a capacitor in a group of capacitors in a plurality of submodules may be determined based on a capacitor voltage of the capacitor, and based on a group current for said group of capacitors. The group current may be a current flowing through an arm of a converter that comprises said plurality of submodules. Such values are typically already available from sensors already present in a converter as part of a control and monitoring system for the converter, as well as the modulation scheme used for the converter (i.e. the time-dependent status of the switches in each submodule).

Still following the example in which the corresponding electrical components are capacitors, the capacitance of each capacitor in each submodule in the group may be determined, and then a group value of capacitance for the group of capacitors may be determined. The group value may be determined directly, or via the component values. For example, in the latter case, the group value for capacitance may be an average (e.g. mean, median) of all of the component values for capacitance.

A significant deviation of any single component value for capacitance from the group value will thus reveal a degraded capacitor. That is, the deviation can advantageously be used to assess a health status of a capacitor without needing to measure the actual temperature of the capacitor, even though the capacitance of the capacitor may also vary with temperature. If the capacitance is determined based on already-available (i.e. sensors already present in the converter for control thereof) electrical information for the converter submodules, then the health of the capacitors in the submodules may advantageously be monitored with no further hardware.

It will be appreciated that the same may apply to the semiconductor switches in the submodules of a capacitor. Any significant deviation in resistance on a component-level, from a group (e.g. average) value therefor, can be attributed to a health status of the deviating semiconductor switch. The group value is the value for the group comprising a corresponding switch from each submodule having a same position in the circuit topology of their respective submodule (e.g. a same position in a half- or full-bridge submodule topology).

The resistance of the semiconductor switches may be determined using dedicated sensors, or based on a collector-emitter voltage, a drain-source voltage, a gate-emitter voltage, a gate-source voltage of said each corresponding semiconductor switch, a group current of the group of corresponding semiconductor switches, and/or or any other characteristic that is an indicator of the health of the components.

It will be further appreciated that, although components in submodules have been referred to above, the same principle applies to the components in a series-connected plurality of ESUs in an ESS.

### BRIEF DESCRIPTION OF THE FIGURES

Exemplifying embodiments will now be described in more detail, with reference to the following appended drawings, wherein:
Figure 1 schematically shows an example converter coupled to an AC power grid, the converter having a plurality of series-connected submodules;
Figure 2 schematically shows an example circuit topology for a submodule of a converter;
Figure 3 schematically shows an example overview of a control and monitoring system for a converter;
Figure 4 schematically shows schematically shows a method for monitoring a converter, according to an aspect of the present disclosure;
Figure 5 diagrammatically illustrates a method for monitoring a converter;
Figure 6 schematically shows an example multi-phase converter topology;
Figure 7 schematically shows an example energy storage system;
Figure 8 schematically shows an example circuit topology for an energy storage unit of an energy storage system; and
Figure 9 schematically shows a power station having a converter and an energy storage system.

### DETAILED DESCRIPTION

Exemplifying embodiments will now be described more fully hereinafter with reference to the accompanying drawings in which currently preferred embodiments are shown. The disclosure may, however, be embodied in many different forms and should not be construed as limited to the embodiments set forth herein; rather, these embodiments are provided for thoroughness and completeness, and fully convey the scope of the disclosure to the skilled person.

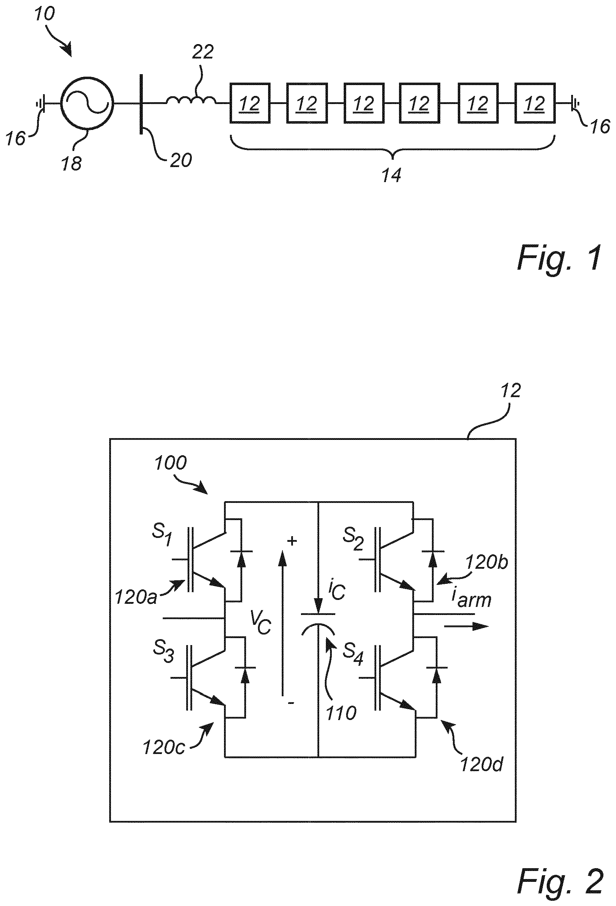

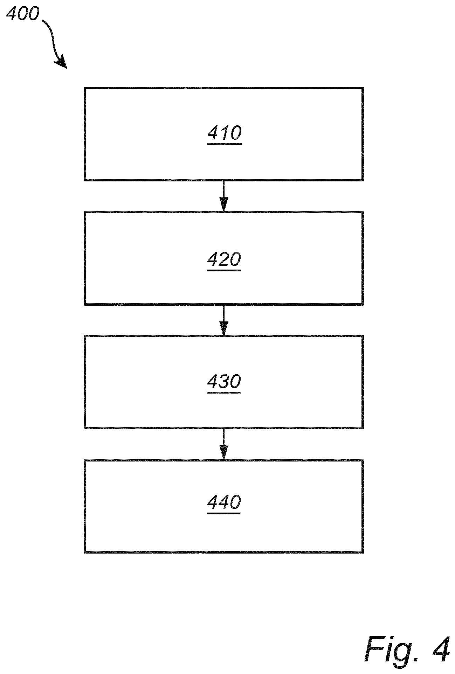

Figure 1 schematically shows an example converter 10 coupled to an AC power grid 18, the converter having a plurality of series-connected submodules 12. The illustrated converter 10 has only one arm 14, which may also be referred to as a 'chain link', although it will be appreciated that the converter 10 may have more arms (e.g. as discussed in relation to figure 4 below).

The converter 10 is grounded at grounding point 16 and is coupled to the AC power grid 18 via a point of coupling (POC) 20, which may be a busbar or a similar component. The converter 10 may further comprise an inductor 22 or the converter 10 may have innate inductance that can be represented as an inductor 22.

A converter 10 such as that shown in figure 1 may be controlled so as to convert electrical energy between DC and AC, for example. Thus, the converter may be a power converter suitable for HVDC applications. Examples sources of such DC electrical energy include solar panels, battery/capacitor banks (i.e. energy storage systems) and the like.

As illustrated in figure 1, the converter 10 comprises six submodules 12 arranged in series, although it will be appreciated that there could be more or fewer submodules 12 in some implementations. That is, the converter 10 comprises a plurality of series-connected submodules 12.

Figure 2 schematically shows an example circuit topology 100 (or simply `topology 100') for a submodule of a converter such as the submodules 12 of the converter 10 shown in figure 1.

As illustrated in figure 2, the circuit topology 100 of the submodule 12 may be a full-bridge submodule topology comprising a capacitor 110 and a plurality of semiconductor switches 120a, 120b, 120c, 120d (collectively 'semiconductor switches 120' or simply 'switches 120'). The switches 120a through 120d are labelled *s*₁ through *s*₄, respectively.

According to this topology 100, current *i*ₐᵣₘ may enter the circuit between the connections of switches 120a and 120c and exit the circuit between the connections of switches 120b and 120d. The current *i*ₐᵣₘ may be a current flowing through the plurality of series-connected submodules 12, such that the same current (*i*ₐᵣₘ) may flow through all of the submodules 12 in the plurality of submodules (e.g. the arm 14 of the converter 10 shown in figure 1).

The terminals of the capacitor 110 may be connected between the connections of switches 120a and 120b, and switches 120c and 120d. Thus, by controlling the switching of the switches 120 (i.e. their on/off state), the direction of current flow across the capacitor 110 can be controlled.

The manner in which the switches 120 are controlled may be referred to as a modulation scheme, e.g. according to a demand on/from the AC power grid 18. The switches 120 of each submodule 12 may be controlled using a same modulation scheme or different modulation schemes, for example with a predetermined delay (or phase difference) between the modulation scheme of different submodules 12.

An example of a modulation scheme may be a phase shifted carrier (PSC) modulation with pulse-width modulation (PWM). The particulars of converter modulation are outside of the scope of the present disclosure. However, a PSC-PWM modulation is an example of a modulation scheme that conforms to an assumption of even power losses across the components of different submodules 12 having a same position in the circuit topology 100. Other modulation schemes may be used, if consideration is paid to this assumption of (substantially) equal average power losses.

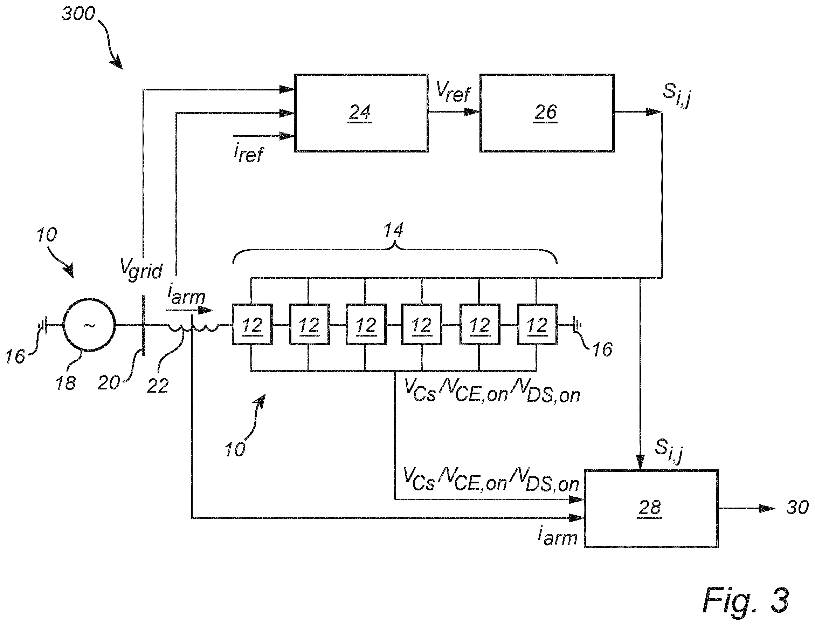

Figure 3 shows an example overview of a control and monitoring system 300 for a converter 10, which may be the same or similar as the converter 10 described above in relation to figures 1 and 2. Further reference is made to these figures in the following description of figure 3.

The converter 10 may be monitored and controlled by a current controller 24 and a modulator 26 such that the switches 120 in the submodules 12 are modulated to create an AC waveform output e.g. for providing to the AC power grid 18. As part of such a control, or as part of a monitoring of the output, the values *i*ₐᵣₘ, *i_{C},* and *v_{C}* may be measured, where i_{C} and *v_{C}* are the current and voltage across the capacitor 110, respectively.

Furthermore, *v_{grid}* may be monitored, and provided to the current controller 24 along with *i*ₐᵣₘ and a reference current *i_{ref}* such that the magnitude, phase, etc. of the output AC waveform can be controlled by the modulator 26 according to a reference voltage *v_{ref}* based on *v_{grid}, i*ₐᵣₘ, and *i_{ref}.*

The modulator 26 may control the switches 120 of the submodules 12 using switching signals *s*_{*i*,*j*} and according to the modulation scheme, where *i* = 1, ..., N for N submodules 12 and *j* = 1, 2, 3, 4 corresponding to switches *s*₁ through *s*₄.

The system 300 may further comprise a health monitor 28 (which may be thought of as another control unit), configured to monitor the health status of electrical components in the converter 10. The health monitor 28 may be provided as a hardware and/or software component, such as a computer having computer-readable instructions to execute a monitoring method.

Such a monitoring method is schematically illustrated as method 400 in figure 4. References to figures 1 to 3 are continued below.

The method may begin by determining 410, for each electrical component in a group, a component value for an electrical characteristic. The 'group' referred to comprises a corresponding electrical component from each submodule 12, in the plurality of submodules 12, having a same position in the circuit topology 100 of their respective submodule 12. The group may be, for example, all of the submodules 12 in an arm 14 of a converter 10, or a subset thereof.

The method 400 further comprises determining 420, for the group of electrical components, a group value for the electrical characteristic. The group value may be directly determinable or it may be determined as an average value (e.g. mean or median) of the component values for the electrical characteristic.

Thereafter, the method 400 comprises determining 430 a deviation of the component value from the group value, for each electrical component in the group, and determining 440 a health status for an electrical component of the group based on the determined deviation for the electrical component.

As an example of the above-described method 400, in the context of the converter 10 described in relation to figures 1 to 3, it may be desired to monitor a health status of the capacitor 110 for a plurality of submodules 12 having the same circuit topology 100 as that shown in figure 2.

Accordingly, a method for monitoring a converter (e.g. converter 10) comprising the plurality of submodules 12 as a series-connected string 14 may comprise determining, for each capacitor 110 in a group, a component value for capacitance.

In this case, it will be appreciated that the capacitors 110 in each submodule clearly have the same position in the circuit topology 100. If it were instead desired that the switches 120 were monitored for a health status, the group may be selected to include only switches corresponding to *s*₁ 120a in the circuit topology (i.e. between the input of the current and a first terminal of the capacitor 110). Accordingly, and considering that the modulation scheme (i.e. switching signals *s_{i,j}*) output by the modulator 26 may be chosen for even average power losses, it will be ensured that each switch 120a in the group will experience a same electrical behavior and, consequently, each switch 120a in the group can be expected to experience the same thermal variations during operations.

The capacitance for the capacitor 110 may be calculated using a dedicated sensor. However, in some examples, the capacitance of the capacitor 110 may be calculated based on *i*ₐᵣₘ and *v_{C}* (or *i_{C}*, which may be related to *v_{C}*). Hence, advantageously, no further electrical sensors may be required to determine the capacitance of the capacitor 110. The switching signals *s_{i,j}* may also be included in said determining of the capacitance.

As shown in figure 3, the outputs *v_{C}*, *i*ₐᵣₘ, and *s_{i,j}* may be fed into the health monitor 28. In some examples, the outputs *v_{CE,on}* (the collector-emitter voltage for one or more of the semiconductor switches 120), *v_{DS,on}* (the drain-source voltage for one or more of the semiconductor switches 120) may also be provided to the health monitor 28, for use in monitoring the semiconductor switches 120.

As part of the method for monitoring the converter 10, a group value for the capacitance of all capacitors 110 in the group (e.g. the capacitor 110 in each submodule 12 in the arm 14 of the converter 10) is determined.

The group value may be directly determined or determinable using a sensor or a calculation, or the group value may be an average value of the component values such as a mean value or a median value. For example, the capacitance for each of the six capacitors 110 (one per submodule 12 illustrated in figure 3, where each submodule has the topology 100 shown in figure 2) may be determined. Thereafter, the mean of these six component values for the capacitance may be taken to provide a group value for the group of six capacitors 110.

The output 30 of the health monitor 28 may comprise the component values (e.g. six values for capacitance - one for each monitored capacitor) and/or the group value (e.g. an average capacitance value for the group).

Based on these component values and the group value for capacitance, a determination can be made of a deviation, for each (or at least one) capacitor 110, of the component value for capacitance for said capacitor 110 from the group value. The determined deviation(s) may be calculated by the health monitor 28 and comprised in the output 30 or it may be calculated by another part of the system 300, e.g. as part of a system-wide control unit. Thus, six deviations (one for each capacitor 110 in the group) may be determined.

An aged capacitor may lose its functional capacitance over time. Some capacitors (e.g. MPPF capacitors) also have a negative temperature coefficient in respect of their capacitance, such that their capacitance may decrease with temperature.

Hence, for each capacitor 110 in the group, the deviation of their associated component value for capacitance from the group value can be used to isolate ageing-related changes in capacitance from temperature-related changes, as all capacitors 110 in the group will experience the same thermal changes (assuming also that they share the same ambient temperature, e.g. in the same room or area).

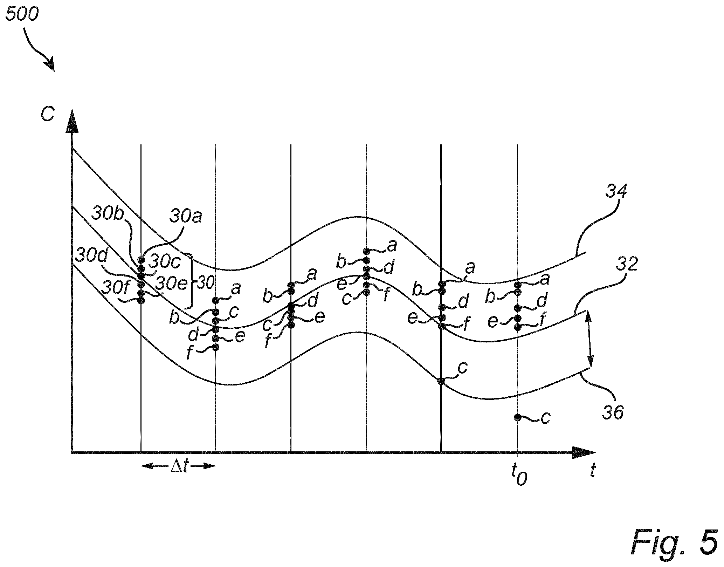

An illustrative representation of an output 30 from the health monitor is shown in figure 5, in the form of a diagram 500, wherein an electrical characteristic 510 (in this case, capacitance *C* to continue with the foregoing example implementation) is plotted against time *t*.

In this example, and for simplicity, it is illustrated that outputs 30a-f (collectively 'outputs 30') corresponding to each of the six capacitors 110 in the group are generated by the health monitor 28 at the same time, and after a repeating time interval Δ*t.* It will be appreciated that outputs 30 (i.e. component values for capacitance) for different capacitors 110 (e.g. from sensors or from calculation based on e.g. *v_{C}* and *iₐᵣₘ)* may be output at different times and/or at different rates.

In this example, the group value is an average value 32 of the outputs 30 and is plotted on the diagram 500. An upper limit 34 and a lower limit 36, e.g. relative to the average value 32 are also shown. In the illustrated example, the limits 34 and 36 are equally arranged around the average and fixed over time. However, it will be appreciated that the upper limit 34 may be further from the average value 32 than the lower limit 36, or vice versa. Furthermore, the limits 34 and 36 may be dynamic, e.g. based on a standard deviation (or range, variation, etc.) of the outputs 30.

As can be seen in the illustrative diagram 500, the outputs 300 have a spread of values, which may be attributed to random, but negligible, differences in the capacitors 110 themselves, e.g. different equivalent series resistances. However, the evolution of the outputs 30 with time should, for healthy capacitors 110, follow a substantially similar path, i.e. with little deviation from the average value 32.

As illustrated, at time *t*₀, the output 30c, corresponding to a component value for capacitance for a particular capacitor in the group, drops below the lower limit 36. This may indicate that the deviation from the group value (i.e. the average value 32 in this example) is large enough to indicate a change in the health status of the capacitor 110 corresponding to the output 30c.

That is, by not substantially following the group value (average value 32), it can be concluded that the reduction in capacitance for output 30c at time *t*₀ (and before) is not due to thermal variations, but to a change in a health status, e.g. an ageing of the capacitor 110.

A notification may then be sent (e.g. by health monitor 28) to a central notification system of, e.g., a power station housing the converter 10, that the submodule 12 containing the capacitor 110 corresponding to output 30c is in need of repair. Advantageously, such a notification will have been generated without the requirement of temperature sensors into the submodules 12 or, in this example, additional electrical sensors for sensing electrical characteristics. Thus, an improved health monitoring system 300 is provided according to the presently disclosed method 400.

It will be appreciated that the presently disclosed method 400 may be applied to a range of electrical systems (e.g. electrical power systems) for which monitoring of an electrical characteristic is desired, without installation of excessive further hardware.

For example, although a converter with a single arm (or chain link) has been considered thus far, it will be appreciated that a converter may have multiple chain links as part of a range of converter topologies.

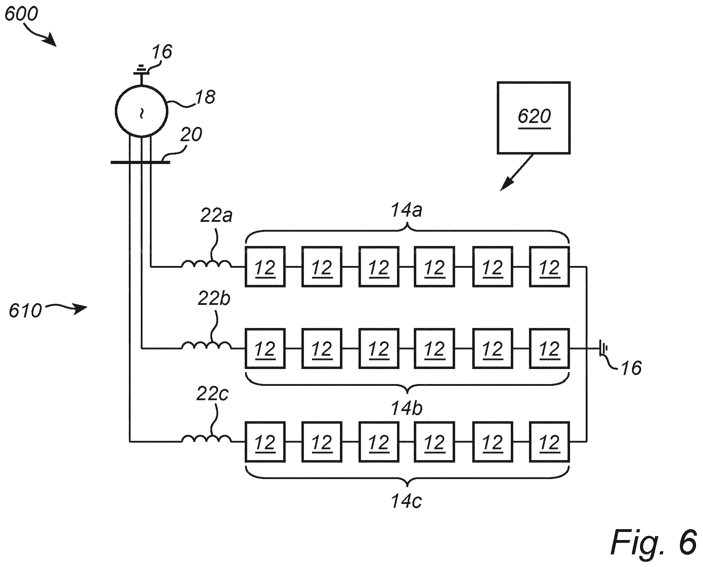

Figure 6 shows an example electrical power system 600 comprising a converter 610 connected to an AC power grid 18 in a similar manner as the converter 10 discussed in relation to figure 1.

The illustrated converter 610 has a 'wye' topology, and comprises a plurality of arms 14a, 14b, and 14c, connected in parallel to the POC 20. Each arm 14 may contribute to a separate phase of the AC power grid 18 such that the three arms 14a, 14b, and 14c correspond to three phases, having respective inductances (e.g. from inductors) 22a, 22b, and 22c.

According to aspects of the present disclosure, components of the submodules 12 of the converter 610 may have their health/condition monitored by the disclosed monitoring method.

Groups of corresponding electrical components may be formed within each arm 14, or a subset thereof. For example, some submodules 12 in the arm 14a may have a half-bridge submodule topology, whilst others have a full-bridge submodule topology. In such a case, groups may be formed from submodules 12 in an arm 14 having a same circuit topology (e.g. grouping all of the half-bridge submodules 12 together and all of the full-bridge submodules 12 together).

The system 600 may further comprise a control unit 620 for implementing the monitoring method. The control unit 620 may be local or remote to the converter 610, e.g. in the same location as the converter 610, or implemented as software on a distributed computing network. It will be appreciated that, in the latter case, all necessary monitored outputs/inputs may need to be directed to the control unit 620 with appropriately low latency.

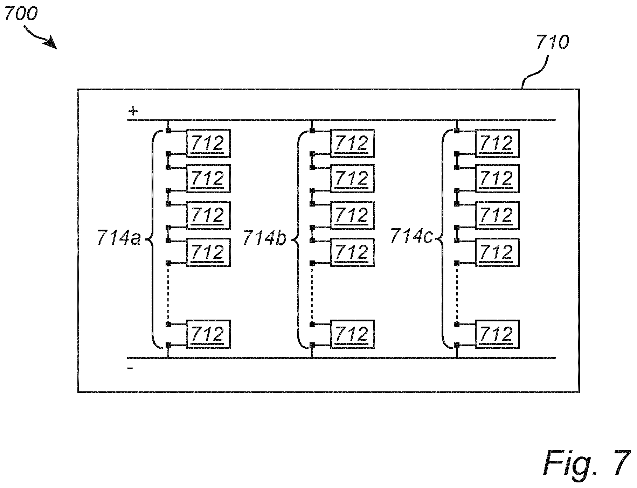

A further electrical system 700 is shown in figure 7, which schematically shows an energy storage system (ESS) 710.

The ESS 710 comprises a plurality of energy storage units (ESUs) 712 arranged in series, in a plurality of strings 714a, 714b, 714c. Each ESU 712 may be configured to store electrical energy, e.g. from an electrical generating means, although the particular functions of the ESS 710 and the ESUs 712 is beyond the scope of the present disclosure.

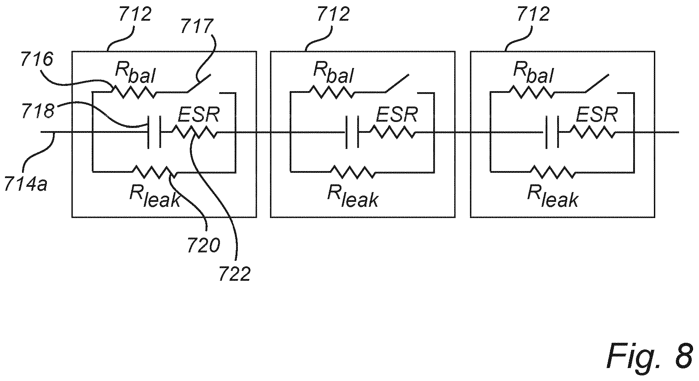

As shown in figure 8, each ESU 712 may comprise a balancing resistor *R_{bal}* 716 controllably engaged by a balancing switch 717. The balancing resistor 716 may be configured to and operated for voltage balancing of the energy storage string 714a. The energy storage of the ESU 712 may be provided by a capacitor 718, or a plurality thereof. It will be appreciated that, in some examples, the energy storage of the ESU 712 may be provided instead by a battery such as a lithium-ion battery or the like.

The ESUs 712 may have an innate leakage resistance *Rₗₑₐₖ* 720 and the ESU 712 may have an equivalent series resistance ESR 722 which may be thought of as an intrinsic resistance of the ESU 712.

The main current passing through all of the capacitors 718 (shared by virtue of the series connection of the ESUs) and the voltage over each capacitor 718 can be measured. Therefore, and by applying the teachings or concept of the present disclosure, as described above in relation to at least Figures 1-6, the capacitance (and/or the ESR value) of all ESUs 712 in the ESS 710 can be monitored for changes indicative of a change in a health status in the electrical components comprised therein.

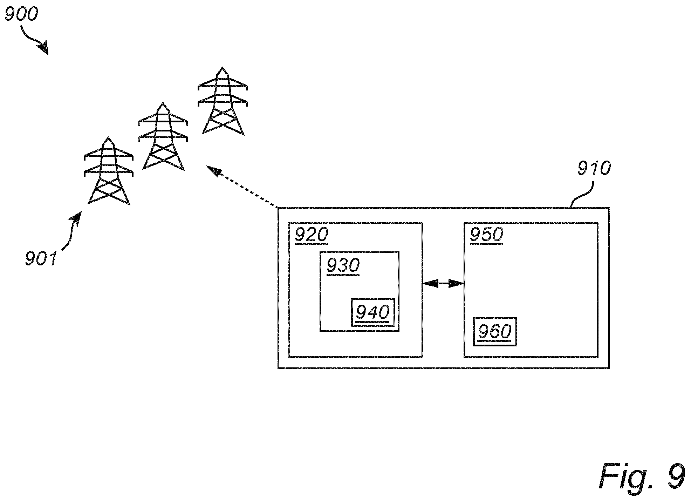

Thus, according to an example implementation of the disclosed methods, there can be provided a system 900 as shown in figure 9.

In the illustrated example, the system comprises a power station 910 for providing power to a power grid 901. The power station 910 may comprise a static compensator (STATCOM) 920 and an energy storage system (ESS) 950, which may be interconnected such that electrical energy stored in the ESS 950 may be provided to the power grid 901 via the converter 920, for example. Together, the STATCOM 920 and the ESS 950 may be referred to as an 'enhanced STATCOM' device or simply E-STATCOM.

The STATCOM 920 may comprise a converter which may be substantially the same or similar to the converter 10 shown in figures 1 to 3 or the converter 610 shown in figure 6 having a 'wye' topology, or another type of (power) converter having another topology, e.g. a delta topology.

The STATCOM 920 may further comprise a control unit 940 for monitoring the health of components of the converter 930 in accordance with the presently disclosed techniques.

The ESS 950 may substantially correspond to the ESS 710 described in relation to figures 7 and 8, and it may further comprise a control unit 960 for monitoring the health of components of the ESS 950 in accordance with the presently disclosed techniques.

The control units 940 and 960 may be part of a same unit, in some examples, and may be local or remote to the power station 910, depending on the particular implementation. In any event, the control units 940 and 960 may be provided with means for carrying out the presently disclosed method for monitoring a converter/ESS so as to provide a power station 910 with a means for rapid detection of unhealthy components, without excessive addition of further sensors.

## Claims

1. A computer-implemented method for monitoring a converter (10) comprising
a plurality of series-connected submodules (12) in an arm (14) of the converter, each submodule having electrical components arranged in a same circuit topology, the method comprising:
determining (410) for each electrical component in a group, a component value for an electrical characteristic;
wherein the group comprises a corresponding electrical component from each submodule, in the plurality of submodules, having a same position in the circuit topology of their respective submodule;
determining (420), for the group of electrical components, a group value for the electrical characteristic,
**characterised in that**
the group value is an average of the component values;
the method further comprising:
determining (430) a deviation of the component value from the group value, for at least one electrical component in the group; and
determining (440) a health status for said at least one electrical component of the group based on the determined deviation for the electrical component.

2. The computer-implemented method according to claim 1, wherein:
the group comprises electrical components from all of the submodules in the arm of the converter, or a subset thereof.

3. The computer-implemented method according to claim 1 or claim 2, wherein:
each submodule comprises a capacitor (110) and a plurality of semiconductor switches (120a, 120b, 120c, 120d); and
the circuit topology is a half-bridge or a full-bridge submodule topology.

4. The computer-implemented method according to claim 3, wherein:
the corresponding electrical component is the capacitor (110);
the group is a group of capacitors (110); and the electrical characteristic is capacitance.

5. The computer-implemented method according to claim 4, wherein:
the capacitance for each capacitor is determined based on: a capacitor voltage (v_{C}) of said each capacitor (110), and
a group current of the group of capacitors, the group current being an arm current, flowing through the arm of the converter.

6. The computer-implemented method according to claim 3, wherein:
the corresponding electrical component is one of the plurality of semiconductor switches;
the group is a group of corresponding semiconductor switches (120a, 120b, 120c, 120d); and
the electrical characteristic is resistance.

7. The computer-implemented method according to claim 6, wherein:
the resistance for each corresponding semiconductor switch (120a, 120b, 120c, 120d) is determined based on:
a collector-emitter voltage, a drain-source voltage, a gate-emitter voltage and/or a gate-source voltage of said each corresponding semiconductor switch, and/or
a group current of the group of corresponding semiconductor switches, the group current being an arm current (iₐᵣₘ), flowing through the arm of the converter.

8. The computer-implemented method according to any preceding claim, wherein:
the electrical characteristic is a temperature-dependent electrical characteristic.

9. A computer-implemented method for monitoring an energy storage system (710) comprising a plurality of series-connected energy storage units, ESUs, 712, each ESU having electrical components arranged in a same circuit topology, the method comprising:
determining, for each electrical component in a group, a component value for an electrical characteristic;
wherein the group comprises a corresponding electrical component from each ESU, 712, in the plurality of ESUs, having a same position in the circuit topology of their respective ESU;
determining, for the group of electrical components, a group value for the electrical characteristic, wherein the group value is an average of the component values;
determining a deviation of the component value from the group value, for at least one electrical component in the group; and
determining a health status for said at least one electrical component of the group based on the determined deviation for the electrical component.

10. A control unit (620) comprising means for carrying out the method according to any of claims 1 to 8.

11. A control unit (940, 960) comprising means for carrying out the method according to claim 9.

12. A power station (910) comprising:
a static synchronous compensator, STATCOM, suitable for a power grid, the STATCOM comprising at least one converter; and
the control unit according to claim 10.

13. The power station (910) according to claim 12, further comprising:
an energy storage system (710) having a plurality of energy storage units (712); and
the control unit according to claim 11.

14. A computer-readable medium comprising instructions which, when executed by a computer, cause the computer to carry out the method according to any of claims 1 to 9.

## Patentansprüche

1. Computerimplementiertes Verfahren zum Überwachen eines Wandlers (10), der mehrere in Reihe verbundene Submodule (12) in einem Arm (14) des Wandlers umfasst, wobei jedes Submodul elektrische Komponenten aufweist, die in einer gleichen Schaltungstopologie angeordnet sind, wobei das Verfahren Folgendes umfasst:
Bestimmen (410), für jede elektrische Komponente in einer Gruppe, eines Komponentenwerts für eine elektrische Charakteristik;
wobei die Gruppe eine entsprechende elektrische Komponente von jedem Submodul in den mehreren Submodulen umfasst, die eine gleiche Position in der Schaltungstopologie ihres jeweiligen Submoduls aufweist;
Bestimmen (420), für die Gruppe von elektrischen Komponenten, eines Gruppenwerts für die elektrische Charakteristik, **dadurch gekennzeichnet, dass** der Gruppenwert ein Mittelwert der Komponentenwerte ist;
wobei das Verfahren ferner Folgendes umfasst:
Bestimmen (430) einer Abweichung des Komponentenwerts von dem Gruppenwert für mindestens eine elektrische Komponente in der Gruppe; und
Bestimmen (440) eines Gesundheitszustands für die mindestens eine elektrische Komponente der Gruppe basierend auf der bestimmten Abweichung für die elektrische Komponente.

2. Computerimplementiertes Verfahren nach Anspruch 1, wobei:
die Gruppe elektrische Komponenten aus allen Submodulen im Arm des Wandlers oder eine Teilmenge davon umfasst.

3. Computerimplementiertes Verfahren nach Anspruch 1 oder Anspruch 2, wobei:
jedes Submodul einen Kondensator (110) und mehrere Halbleiterschalter (120a, 120b, 120c, 120d) umfasst; und
die Schaltungstopologie eine Halbbrücken- oder eine Vollbrücken-Submodultopologie ist.

4. Computerimplementiertes Verfahren nach Anspruch 3, wobei:
die entsprechende elektrische Komponente der Kondensator (110) ist;
die Gruppe eine Gruppe von Kondensatoren (110) ist; und
die elektrische Charakteristik Kapazität ist.

5. Computerimplementiertes Verfahren nach Anspruch 4, wobei:
die Kapazität für jeden Kondensator basierend auf Folgendem bestimmt wird:
eine Kondensatorspannung (v_{C}) jedes Kondensators (110), und
ein Gruppenstrom der Gruppe von Kondensatoren, wobei der Gruppenstrom ein Armstrom ist, der durch den Arm des Wandlers fließt.

6. Computerimplementiertes Verfahren nach Anspruch 3, wobei:
die entsprechende elektrische Komponente einer der mehreren Halbleiterschalter ist;
die Gruppe eine Gruppe entsprechender Halbleiterschalter (120a, 120b, 120c, 120d) ist; und
die elektrische Charakteristik Widerstand ist.

7. Computerimplementiertes Verfahren nach Anspruch 6, wobei:
der Widerstand für jeden entsprechenden Halbleiterschalter (120a, 120b, 120c, 120d) basierend auf Folgendem bestimmt wird:
eine Kollektor-Emitter-Spannung, eine Drain-Source-Spannung, eine Gate-Emitter-Spannung und/oder eine Gate-Source-Spannung jedes entsprechenden Halbleiterschalters, und/oder
ein Gruppenstrom der Gruppe von entsprechenden Halbleiterschaltern, wobei der Gruppenstrom ein Armstrom (iₐᵣₘ) ist, der durch den Arm des Wandlers fließt.

8. Computerimplementiertes Verfahren nach einem der vorhergehenden Ansprüche, wobei:
die elektrische Charakteristik eine temperaturabhängige elektrische Charakteristik ist.

9. Computerimplementiertes Verfahren zum Überwachen eines Energiespeichersystems (710), das mehrere in Reihe verbundene Energiespeichereinheiten, ESUs, 712, umfasst, wobei jede ESU elektrische Komponenten aufweist, die in einer gleichen Schaltungstopologie angeordnet sind, wobei das Verfahren Folgendes umfasst:
Bestimmen, für jede elektrische Komponente in einer Gruppe, eines Komponentenwerts für eine elektrische Charakteristik;
wobei die Gruppe eine entsprechende elektrische Komponente von jeder ESU, 712, in den mehreren ESUs umfasst, die eine gleiche Position in der Schaltungstopologie ihrer jeweiligen ESU aufweist;
Bestimmen, für die Gruppe von elektrischen Komponenten, eines Gruppenwerts für die elektrische Charakteristik, wobei der Gruppenwert ein Mittelwert der Komponentenwerte ist;
Bestimmen einer Abweichung des Komponentenwerts von dem Gruppenwert für mindestens eine elektrische Komponente in der Gruppe; und
Bestimmen eines Gesundheitszustands für die mindestens eine elektrische Komponente der Gruppe basierend auf der bestimmten Abweichung für die elektrische Komponente.

10. Steuereinheit (620), die Mittel zum Ausführen des Verfahrens nach einem der Ansprüche 1 bis 8 umfasst.

11. Steuereinheit (940, 960), die Mittel zum Ausführen des Verfahrens nach Anspruch 9 umfasst.

12. Kraftwerk (910), umfassend:
einen statischen synchronen Kompensator, STATCOM, der für ein Stromnetz geeignet ist, wobei der STATCOM mindestens einen Wandler umfasst; und
die Steuereinheit nach Anspruch 10.

13. Kraftwerk (910) nach Anspruch 12, ferner umfassend:
ein Energiespeichersystem (710) mit mehreren Energiespeichereinheiten (712); und
die Steuereinheit nach Anspruch 11.

14. Computerlesbares Medium, das Anweisungen umfasst, die, wenn sie durch einen Computer ausgeführt werden, bewirken, dass der Computer das Verfahren nach einem der Ansprüche 1 bis 9 ausführt.

## Revendications

1. Procédé mis en œuvre par ordinateur de surveillance d'un convertisseur (10) comprenant une pluralité de sous-modules (12) connectés en série dans un bras (14) du convertisseur, chaque sous-module comportant des composants électriques disposés selon une même topologie de circuit, le procédé comprenant :
la détermination (410), pour chaque composant électrique d'un groupe, d'une valeur de composant pour une caractéristique électrique ;
dans lequel le groupe comprend un composant électrique correspondant de chaque sous-module de la pluralité de sous-modules, ayant une même position dans la topologie de circuit de leur sous-module respectif ;
la détermination (420), pour le groupe de composants électriques, d'une valeur de groupe pour la caractéristique électrique, **caractérisé en ce que** la valeur de groupe est une moyenne des valeurs de composants ;
le procédé comprenant en outre :
la détermination (430) d'un écart de la valeur de composant par rapport à la valeur de groupe, pour au moins un composant électrique du groupe ; et
la détermination (440) d'un état de santé pour ledit au moins un composant électrique du groupe sur la base de l'écart déterminé pour le composant électrique.

2. Procédé mis en œuvre par ordinateur selon la revendication 1, dans lequel :
le groupe comprend des composants électriques de tous les sous-modules dans le bras du convertisseur, ou un sous-ensemble de ceux-ci.

3. Procédé mis en œuvre par ordinateur selon la revendication 1 ou la revendication 2, dans lequel :
chaque sous-module comprend un condensateur (110) et une pluralité de commutateurs à semi-conducteurs (120a, 120b, 120c, 120d) ; et
la topologie de circuit est une topologie en demi-pont ou de sous-module en pont complet.

4. Procédé mis en œuvre par ordinateur selon la revendication 3, dans lequel :
le composant électrique correspondant est le condensateur (110) ;
le groupe est un groupe de condensateurs (110) ; et
la caractéristique électrique est la capacité.

5. Procédé mis en œuvre par ordinateur selon la revendication 4, dans lequel :
la capacité pour chaque condensateur est déterminée sur la base :
d'une tension de condensateur (v_{C}) de chaque dit condensateur (110), et
d'un courant de groupe du groupe de condensateurs, le courant de groupe étant un courant de bras, circulant dans le bras du convertisseur.

6. Procédé mis en œuvre par ordinateur selon la revendication 3, dans lequel :
le composant électrique correspondant est l'un parmi la pluralité de commutateurs à semi-conducteurs ;
le groupe est un groupe de commutateurs à semi-conducteurs (120a, 120b, 120c, 120d) correspondants ; et
la caractéristique électrique est la résistance.

7. Procédé mis en œuvre par ordinateur selon la revendication 6, dans lequel :
la résistance pour chaque commutateur à semi-conducteur (120a, 120b, 120c, 120d) correspondant est déterminée sur la base :
d'une tension collecteur-émetteur, d'une tension drain-source, d'une tension grille-émetteur, et/ou d'une tension grille-source de chaque dit commutateur à semi-conducteur correspondant, et/ou
d'un courant de groupe du groupe de commutateurs à semi-conducteurs correspondants, le courant de groupe étant un courant de bras (iₐᵣₘ), circulant dans le bras du convertisseur.

8. Procédé mis en œuvre par ordinateur selon l'une quelconque des revendications précédentes, dans lequel :
la caractéristique électrique est une caractéristique électrique dépendant de la température.

9. Procédé mis en œuvre par ordinateur de surveillance d'un système de stockage d'énergie (710) comprenant plusieurs unités de stockage d'énergie, ESU, 712 connectées en série, chaque ESU comportant des composants électriques disposés selon une même topologie de circuit, le procédé comprenant :
la détermination, pour chaque composant électrique d'un groupe, d'une valeur de composant pour une caractéristique électrique ;
dans lequel le groupe comprend un composant électrique correspondant de chaque ESU, 712, de la pluralité d'ESU, ayant une même position dans la topologie de circuit de leur ESU respective ;
la détermination, pour le groupe de composants électriques, d'une valeur de groupe pour la caractéristique électrique, dans lequel la valeur de groupe est une moyenne des valeurs de composants,
la détermination d'un écart entre la valeur de composant et la valeur de groupe, pour au moins un composant électrique du groupe ; et
la détermination d'un état de santé dudit au moins un composant électrique du groupe sur la base de l'écart déterminé pour le composant électrique.

10. Unité de commande (620), comprenant des moyens pour mettre en œuvre le procédé selon l'une quelconque des revendications 1 à 8.

11. Unité de commande (940, 960), comprenant des moyens pour mettre en œuvre le procédé selon la revendication 9.

12. Station électrique (910), comprenant :
un compensateur synchrone statique, STATCOM, approprié pour un réseau électrique, le STATCOM comprenant au moins un convertisseur ; et
l'unité de commande selon la revendication 10.

13. Station électrique (910) selon la revendication 12, comprenant en outre :
un système de stockage d'énergie (710) comportant une pluralité d'unités de stockage d'énergie (712) ;
et
l'unité de commande selon la revendication 11.

14. Support lisible par ordinateur comprenant des instructions qui, lorsqu'elles sont exécutées par un ordinateur, amènent l'ordinateur à mettre en œuvre le procédé selon l'une quelconque des revendications 1 à 9.
